# EUROPÄISCHE PATENTSCHRIFT

(11) **EP 2 936 261 B1**
(45) Veröffentlichungstag und Bekanntmachung des Hinweises auf die Patenterteilung: **20.01.2021**
(21) Anmeldenummer: 13818719.0
(22) Anmeldetag: 18.12.2013
(51) Int. Cl.: G05B 19/418, B01J 19/00

(54) **COMPUTERIMPLEMENTIERTES VERFAHREN ZUM HERSTELLEN EINES PRODUKTIONSANLAGENMODELLS**
COMPUTERIZED METHOD FOR PRODUCING A PRODUCTION PLANT MODEL
PROCÉDÉ DE CRÉATION PAR ORDINATEUR D'UN MODÈLE D'INSTALLATION DE PRODUCTION

(30) Priorität: 20.12.2012 DE 102012112775
(43) Veröffentlichungstag der Anmeldung: 28.10.2015
(73) Patentinhaber: Bayer Aktiengesellschaft, 51373 Leverkusen (DE)
(72) Erfinder: FRYE, Lars Dr., 42799 Leichlingen (DE); GÜNTHER, Dietmar, 42499 Hückeswagen (DE); KRASBERG, Nicolai, 40764 Langenfeld (DE)
(74) Vertreter: BIP Patents
(86) Internationale Anmeldenummer: PCT/EP2013/077050
(87) Internationale Veröffentlichungsnummer: WO 2014/095972

(56) Entgegenhaltungen:
- DE-U1-212009 000 008
- US-B1- 6 470 301
- MARTINA ERDWIENS ET AL: "Grundlagen für die rechnergestützte Aufstellungsplanung", CHEMIE INGENIEUR TECHNIK, Bd. 67, Nr. 7, 1. Juli 1995 (1995-07-01), Seiten 853-861, XP055111058, ISSN: 0009-286X, DOI: 10.1002/cite.330670706
- Oliver Ritthoff ET AL: "Merkmalsbasiertes Lernen von Platzierungsregeln im Rahmen der Aufstellungsplanung von Chemieanlagen", , 1. September 2004 (2004-09-01), XP055111896, Gefunden im Internet: URL:http://sfbci.uni-dortmund.de/Publicati ons/Reference/Downloads/17904.pdf [gefunden am 2014-04-03]

## Beschreibung

Die vorliegende Erfindung betrifft ein computerimplementiertes Verfahren zum Herstellen eines zweidimensionalen Anlagenmodells einer modular aufgebauten Produktionsanlage für die Produktion eines chemischen Produktes.

Für die Herstellung eines bestimmten chemischen Produktes ist es erforderlich, eine Produktionsanlage mit individuell gestalteter Anlagenstruktur bereitzustellen, um die jeweilig verfahrenstechnisch erforderlichen Prozessschritte in einzelnen Prozessabschnitten durchführen zu können. Ist die Herstellung dieses bestimmten Produkts nicht mehr gewünscht, wird die Produktionsanlage üblicherweise wieder abgebaut, um an derselben Stelle eine andere Produktionsanlage mit individuell gestalteter Anlagenstruktur aufbauen zu können, mit der ein anderes chemisches Produkt hergestellt werden kann. Dieses Auf- und Abbauen von Produktionsanlagen ist sehr zeit- und kostenaufwändig. Es besteht daher ein ständiges Bedürfnis, den mit der Produktion verschiedener chemischer Produkte verbundenen Aufwand zu verringern. Jedes der Dokumente 'M. Erdwiens et al.: "Grundlagen für die rechnergestützte Aufstellungsplanung", Chemie Ingenieur Technik, Bd. 67, Nr. 7, 1. Juli 1995' und 'O. Ritthoff et al.: "Merkmalsbasiertes Lernen von Platzierungsregeln im Rahmen der Aufstellungsplanung von Chemieanlagen", 1. September 2004' beschreibt ein computerimplementiertes Verfahren zum Herstellen eines zweidimensionalen Anlagenmodells einer modular aufgebauten Produktionsanlage für die Produktion eines chemischen Produktes.

Aufgabe der Erfindung ist es, ein neuartiges Anlagenkonzept bereitzustellen, mit dem der mit der Produktion verschiedener chemischer Produkte verbundene Aufwand deutlich gegenüber der herkömmlichen Vorgehensweise verringert werden kann.

Diese Aufgabe wird durch eine Produktionsanlage mit den Merkmalen gemäß Patentanspruch 1 gelöst. Bevorzugte Ausgestaltungen sind in den Unteransprüchen angegeben, die jeweils für sich genommen oder in beliebiger Kombination miteinander einen Aspekt der Erfindung darstellen können.

Mit Patentanspruch 1 wird ein computerimplementiertes Verfahren zum Herstellen eines zweidimensionalen Anlagenmodells einer modular aufgebauten Produktionsanlage für die Produktion eines chemischen Produktes vorgeschlagen, wobei die Produktionsanlage wenigstens zwei produktionstechnisch miteinander verbindbare Prozessmodule und mindestens einen Prozesscontainer aufweist, in dem die Prozessmodule zumindest teilweise bestimmungsgemäß unterbringbar sind,
- wobei zu jedem Prozesscontainer ein gemeinsames zweidimensionales Containermodell seiner Grundfläche und der Grundfläche einer den Prozesscontainer zumindest teilweise umgebenden Containerumgebung vorgebbarer Größe erzeugt wird,
- wobei zu jedem Prozessmodul ein zweidimensionales Modulmodell seiner Grundfläche erzeugt wird,
- wobei das Containermodell und die Modulmodelle in gleichgroße, vorzugsweise quadratische, Rasterfelder aufgeteilt werden,
- wobei jedem Rasterfeld eines Modulmodells eine Moduleigenschaft bezüglich der Belegung des jeweiligen Rasterfeldes mit einer oberhalb des diesem Rasterfeld entsprechenden Abschnitts der Grundfläche des jeweiligen Prozessmoduls angeordneten, funktionellen Einrichtung des jeweiligen Prozessmoduls, mit einem oberhalb des diesem Rasterfeld entsprechenden Abschnitts der Grundfläche des jeweiligen Prozessmoduls angeordneten, dem Prozessmodul zugewiesenen Bedienraum oder mit einem oberhalb des diesem Rasterfeld entsprechenden Abschnitts der Grundfläche des jeweiligen Prozessmoduls angeordneten stofflichen Ausgang des Prozessmoduls zugeordnet wird,
- wobei jedem Rasterfeld des Containermodells eine Belegungseigenschaft bezüglich der Belegbarkeit bzw. Nichtbelegbarkeit des jeweiligen Rasterfeldes mit einer Moduleigenschaft zugeordnet wird,
- wobei die Modulmodelle unter Berücksichtigung der Moduleigenschaften und der Belegungseigenschaften in dem Containermodell angeordnet werden.

Die Produktionsanlage kann auch zwei oder mehrere produktionstechnisch miteinander verbindbare Prozesscontainer aufweisen. Die Prozesscontainer sind vorzugsweise als Ganzes transportierbare Einheiten, welche zu einem gewünschten Produktionsort, an dem eine entsprechend ausgestattete Produktionsanlage aufgestellt werden soll, transportierbar bzw. von diesem Ort nach Abschluss der gewünschten Produktion weg transportierbar sind. Dies ermöglicht eine einfache und produktionskostenreduzierende Wiederverwendung einzelner Prozesscontainer an verschiedenen Produktionsorten. Hierzu kann ein Prozesscontainer ein einen einfachen Transport des Prozesscontainers ermöglichendes Gehäuse aufweisen, in dem zur Durchführung eines Gesamtprozesses oder eines bestimmten Prozessabschnitts geeignete Prozessmodule angeordnet und produktionstechnisch miteinander verbunden sind. Ein Prozesscontainer kann beispielsweise Funktionalitäten zum Heizen, Kühlen, Vermischen, Trennen, Druckregelen, Belüften und/oder Entlüften aufweisen, die es ermöglichen eine chemische Reaktion durchzuführen und Reaktionsbedingungen zu regeln. Ein Prozesscontainer kann zudem zur eigenständigen Durchführung eines Gesamtprozesses oder eines bestimmten Prozessabschnitts der Produktion eingerichtet sein. Eigenständig bedeutet hierbei, dass der Prozessabschnitt mittels des Prozesscontainers durchgeführt wird, ohne dass hierzu eine Steuerung und/oder Regelung des Prozessabschnitts oder eines Teils davon von einer Einrichtung abseits des Prozesscontainers erfolgen muss.

An einem Produktionsort kann wenigstens ein Prozesscontainer, vorzugsweise über standardisierte Kupplungen, an ein fest installiertes Kommunikationsnetz und/oder an ein Versorgungsnetz angeschlossen werden, mit dem der Prozesscontainer mit Stoff und/oder Energie versorgt werden kann und/oder in das Stoffe abgegeben werden können, so dass mittels des Prozesscontainers im Wesentlichen autonom wenigstens eine chemische Batch-Reaktion und/oder eine kontinuierliche Produktion durchgeführt werden kann. Beispielsweise kann das Versorgungsnetz eine Druckluftleitung zur Zufuhr von Druckluft, eine Speisewasserleitung zur Zufuhr von Wasser, eine Elektroleitung zur Zufuhr von elektrischer Energie, eine Stoffleitung zur Zufuhr von Edukten und/oder Hilfsstoffen und/oder zur Abfuhr von Produkten, Nebenprodukten und/oder Abfallstoffen, eine Kühlleitung zur Zufuhr von Kälte beziehungsweise zur Abfuhr von Wärme und/oder eine Heizleitung zur Zufuhr von Wärme beziehungsweise zur Abfuhr von Kälte aufweisen. Als Kommunikationsnetz kommen verschiedene kabelgebundene oder kabellose Kommunikationsnetze in Betracht. Über das Kommunikationsnetz kann ein standardisierter Informationsaustausch der an das Kommunikationsnetz angeschlossenen Prozesscontainer untereinander und/oder mit über- oder untergeordneten Einrichtungen erfolgen.

Die produktionstechnisch miteinander verbindbaren Prozessmodule sind bestimmungsgemäß zumindest teilweise in einem Prozesscontainer anordbar. Bei der erfindungsgemäßen Produktionsanlage ist die Gesamtanordnung aus einzelnen Prozessmodulen pro Prozesscontainer hinsichtlich ihres räumlichen Platzbedarfs und des zu ihrer bestimmungsgemäßen Anordnung erforderlichen Materialbedarfs minimiert, so dass insbesondere eine maximale Anzahl von Prozessmodulen in einem Prozesscontainer anordbar ist, wodurch die Variabilität der Bestückung eines Prozesscontainers mit Prozessmodulen erhöht wird. Gleiches gilt folglich für die Variabilität der mit einem Prozesscontainer durchführbaren Prozesse oder Prozessabschnitte.

Das Containermodell und die Modulmodelle werden in gleichgroße Rasterfelder aufgeteilt. Die Rasterfelder sind vorzugsweise quadratisch ausgebildet. Alternativ können die Rasterfelder kreisförmig ausgebildet sein. Des Weiteren ist eine rechteckige oder ellipsenförmige Ausgestaltung der Rasterfelder möglich, wodurch jedoch die Anordbarkeit der Prozessmodule relativ zu dem Prozesscontainer gegenüber einer quadratischen oder kreisförmigen Ausgestaltung der Rasterfelder eingeschränkt ist. Grundsätzlich sind auch anderweitig polygonal oder oval ausgestaltete Rasterfelder einsetzbar, die kongruent zueinander ausgebildet sind.

Die Moduleigenschaften und der Belegungseigenschaften stellen Randbedingungen bezüglich der Anordnung der einzelnen Prozessmodule relativ zueinander und relativ zu dem Prozesscontainer dar. Bei der Produktionsanlage erfolgt somit eine optimale Zuordnung von Bestandteilen der Prozessmodule zu den den Rasterfeldern des Containermodells entsprechenden Abschnitten der Grundfläche des Containers und seiner Umgebung vorgebbarer Größe.

Als funktionelle Einrichtung kommt beispielsweise eine Ausrüstung zum Heizen, Kühlen, Vermischen, Trennen, Druckregelen, Belüften und/oder Entlüften oder ein stofflicher Eingang in Betracht. Des Weiteren kann eine funktionelle Einrichtung ein an ein lokales Versorgungsnetz anschließbarer Speicher für Stoff und/oder Energie sein.

Die Belegungseigenschaften des Containermodells werden vorzugsweise ausgewählt aus einer Gruppe, die zumindest die Eigenschaften "nicht belegbar", "nur mit Bedienraum belegbar", "nur mit funktioneller Einrichtung belegbar", "bevorzugt nicht belegt", "bevorzugt mit Bedienraum belegt" und "bevorzugt mit funktioneller Einrichtung belegt" umfasst.

Erfindungsgemäß wird jedem Rasterfeld des Containermodells eine der Eigenschaften "innerhalb des Containers" oder "außerhalb des Containers" zugeordnet. Dies stellt ein weiteres Kriterium bei der Anordnung der Prozessmodule relativ zu dem Prozesscontainer dar. Weist ein Rasterfeld des Containermodells die Eigenschaft "innerhalb des Containers" auf, so liegt dieses Rasterfeld vollständig innerhalb der Grundfläche des tatsächlichen Prozesscontainers. Weist ein Rasterfeld des Containermoduls hingegen die Eigenschaft "außerhalb des Containers" auf, so liegt dieses Rasterfeld vollständig außerhalb der Grundfläche des tatsächlichen Prozesscontainers, jedoch vollständig innerhalb der Grundfläche der tatsächlichen Umgebung begrenzter, vorgebbarer Größe. Rasterfelder eines Prozessmoduls, welchen eine funktionelle Einrichtung des jeweiligen Prozessmoduls zugeordnet ist, werden vorzugsweise auf Rasterfeldern des Containermodells angeordnet, welche die Eigenschaft "innerhalb des Containers" aufweisen.

Nach einer weiteren vorteilhaften Ausgestaltung wird jedem Rasterfeld des Containermodells ein absolutes, ganzzahliges Koordinatenpaar (x_{abs}, y_{abs}) zugeordnet, wobei der Ursprung des zugrundeliegenden absoluten Koordinatensystems innerhalb der Grundfläche des Prozesscontainers angeordnet wird. Hierdurch sind die Rasterfelder des Containermodells auf einfache Art und Weise individualisierbar, was die Zuordnung von Eigenschaften zu den einzelnen Rasterfeldern des Containermodells vereinfacht.

Vorteilhafterweise wird jedem Rasterfeld eines Modulmodells ein ganzzahliges, relatives Koordinatenpaar (xᵣₑₗ, yᵣₑₗ) zugeordnet, wobei der Ursprung des zugrundeliegenden relativen Koordinatensystems innerhalb der Grundfläche des Prozessmoduls angeordnet wird. Hierdurch sind auch die Rasterfelder eines Modulmodells auf einfache Art und Weise individualisierbar, was die Zuordnung von Eigenschaften zu den einzelnen Rasterfeldern des jeweiligen Modulmodells vereinfacht.

Es wird weiter als vorteilhaft erachtet, wenn jedem Modulmodell eine Position in dem absoluten Koordinatensystem zugeordnet wird, welche durch die Position des Ursprungs des jeweiligen relativen Koordinatensystems innerhalb des absoluten Koordinatensystems definiert wird. Die relative Anordbarkeit eines Modulmodells zu dem Containermodell stellt einen ersten Freiheitsgrad der zu optimierenden Anordnung der Prozessmodule relativ zu dem Prozesscontainer dar.

Bevorzugt wird jedem Modulmodell eine Ausrichtung relativ zu dem absoluten Koordinatensystem zugeordnet. Sind das Containermodell und die Modulmodelle beispielsweise in quadratische Rasterfelder unterteilt, kann ein Modulmodell unter den Relativwinkeln 0°, 90°, 180° oder 270° relativ zu dem absoluten Koordinatensystem ausgerichtet werden. Diese relative Ausrichtbarkeit zwischen Modulmodellen und Containermodell stellt einen zweiten Freiheitsgrad der zu optimierenden Anordnung der Prozessmodule relativ zu dem Prozesscontainer dar.

Nach einer weiteren vorteilhaften Ausgestaltung werden alle möglichen Verbindungsvarianten zwischen Rasterfeldern verschiedener Modulmodelle, denen jeweils eine funktionellen Einrichtungen zugeordnet ist, ermittelt, wobei jede Verbindungsvariante mit einem Wert aus einem vorgebbaren Wertebereich, insbesondere aus dem Wertebereich {-100,..., 100}, gewichtet wird. Die Verbindungsvarianten werden beispielsweise unter Berücksichtigung von stofflichen und technischen Verbindungen bzw. Beziehungen zwischen den einzelnen relativ zu einem Prozesscontainer anzuordnenden Prozessmodulen ermittelt. Stoffliche Beziehungen können sich aus gegebenen Stoff- und Abfallströmen ergeben. Technische Beziehungen können durch Distanzanforderungen zwischen nicht zueinander kompatiblen Einrichtungen von Prozessmodulen begründet sein.

Vorzugsweise führen Verbindungsvarianten, die mit einem negativen Wert gewichtet sind, zu einer Maximierung des Abstandes zwischen diesen Verbindungsvarianten zugehörigen Rasterfeldern, und Verbindungsvarianten, die mit einem positiven Wert gewichtet sind, zu einer Minimierung des Abstandes zwischen diesen Verbindungsvarianten zugehörigen Rasterfeldern. Eine Maximierung des Abstandes kann beispielsweise zwischen nicht kompatiblen technischen Einrichtungen gegeben sein. Eine Minimierung des Abstandes kann beispielsweise zur Reduzierung der Länge von Rohrleitungen zwischen technischen Einrichtungen von Prozessmodulen dienen.

Es wird weiter als vorteilhaft erachtet, wenn bei mehreren Verbindungsvarianten mit vergleichbaren Gewichtungen mit positiven Werten diejenige Verbindungsvariante ausgewählt wird, welche mit dem kleinsten positiven Wert gewichtet ist.

Gemäß einer weiteren vorteilhaften Ausgestaltung erfolgt die Anordnung der Modulmodelle in dem Containermodell des Weiteren unter Berücksichtigung von wenigstens einer der weiteren Bedingungen, ausgewählt aus der Gruppe:
- mit einem Rasterfeld eines Modulmodells, dem eine funktionelle Einrichtung des jeweiligen Prozessmoduls zugeordnet ist, darf nicht ein Rasterfeld des Containermodells belegt werden, das bereits mit einem Rasterfeld eines weiteren Modulmodells belegt ist, dem eine funktionelle Einrichtung des jeweiligen weiteren Prozessmoduls zugeordnet ist;
- mit einem Rasterfeld eines Modulmodells, dem ein dem jeweiligen Prozessmodul zugewiesener Bedienraum zugeordnet ist, darf nicht ein Rasterfeld des Containermodells belegt werden, das bereits von einem Rasterfeld eines weiteren Modulmodells belegt ist, dem eine funktionelle Einrichtung des jeweiligen weiteren Prozessmoduls zugeordnet ist;
- mit einem Rasterfeld eines Modulmodells, dem eine funktionelle Einrichtung des jeweiligen Prozessmoduls zugeordnet ist, darf nicht ein Rasterfeld des Containermodells belegt werden, dem die Belegungseigenschaft "nicht belegbar" oder "nur mit Bedienraum belegbar" zugeordnet ist;
- mit einem Rasterfeld eines Modulmodells, dem ein dem jeweiligen Prozessmodul zugewiesener Bedienraum zugeordnet ist, darf nicht ein Rasterfeld des Containermodells belegt werden, dem die Belegungseigenschaft "nicht belegbar" oder "nur mit funktioneller Einrichtung belegbar" zugeordnet ist.

Vorzugsweise erfolgt die Anordnung der Modulmodelle in dem Containermodell unter Berücksichtigung aller dieser weiteren Bedingungen.

Nach einer weiteren vorteilhaften Ausgestaltung erfolgt die Anordnung der Modulmodelle in dem Containermodell des Weiteren unter Berücksichtigung von wenigstens einer der weiteren Bedingungen, ausgewählt aus der Gruppe:
- ein Rasterfeld eines Modulmodells, dem ein dem jeweiligen Prozessmodul zugewiesener Bedienraum zugeordnet ist, sollte auf einem Rasterfeld des Containermodells angeordnet werden, das bereits von einem Rasterfeld eines weiteren Modulmodells belegt ist, dem ein dem jeweiligen weiteren Prozessmodul zugewiesener Bedienraum zugeordnet ist;
- ein Rasterfeld eines Modulmodells, dem eine funktionelle Einrichtung des jeweiligen Prozessmoduls zugeordnet ist, sollte auf einem Rasterfeld des Containermodells angeordnet werden, dem die Belegungseigenschaft "nur mit funktioneller Einrichtung belegbar" oder "bevorzugt mit funktioneller Einrichtung belegt" zugeordnet ist;
- ein Rasterfeld eines Modulmodells, dem ein dem jeweiligen Prozessmodul zugewiesener Bedienraum zugeordnet ist, sollte auf einem Rasterfeld des Containermodells angeordnet werden, dem die Belegungseigenschaft "nur mit Bedienraum belegbar" oder "bevorzugt mit Bedienraum belegt" zugeordnet ist;
- ein Rasterfeld eines Modulmodells, dem eine funktionelle Einrichtung des jeweiligen Prozessmoduls zugeordnet ist, sollte auf einem Rasterfeld des Containermodells angeordnet werden, das bereits mit einem Rasterfeld eines weiteren Modulmodells belegt ist, dem ein stofflicher Ausgang des jeweiligen weiteren Prozessmoduls zugeordnet ist;
- ein Rasterfeld eines Modulmodells, dem ein stofflicher Ausgang des jeweiligen Prozessmoduls zugeordnet ist, sollte auf einem Rasterfeld des Containermodells angeordnet werden, das bereits mit einem Rasterfeld eines weiteren Modulmodells belegt ist, dem eine funktionelle Einrichtung des jeweiligen weiteren Prozessmoduls zugeordnet ist.

Bevorzugt erfolgt die Anordnung der Modulmodelle in dem Containermodell auch unter Berücksichtigung aller dieser weiteren Bedingungen.

Nach einer weiteren vorteilhaften Ausgestaltung erfolgt die Anordnung der Modulmodelle in dem Containermodell des Weiteren unter Berücksichtigung von wenigstens einer der weiteren Bedingungen, ausgewählt aus der Gruppe:
- die Prozessmodule sollten über eine Längsseite des Prozesscontainers in diesen einbringbar sein;
- Bedienräume und Wartungsräume der Prozessmodule sollten nach bestimmungsgemäßer Anordnung der Prozessmodule zugänglich sein;
- die Prozessmodule sollten einzeln aus dem Prozesscontainer entfernbar bzw. in diesen einbaubar sein, ohne dass hierzu andere Prozessmodule entfernt werden müssen;
- Prozessströme zwischen bestimmungsgemäß angeordneten Prozessmodulen sollten nicht dritte Prozessmodule schneiden.

Es wird weiter als vorteilhaft erachtet, wenn die Anordnung der Modulmodelle in dem dem Prozesscontainer zugeordneten Containermodell unter Berücksichtigung der Anordnung von Modulmodellen in einem einem weiteren Prozesscontainer zugeordneten weiteren Containermodell erfolgt, wobei der weitere Prozesscontainer über, unter oder neben dem Prozesscontainer angeordnet wird. Diese Ausgestaltung begründet weitere Randbedingungen für die Anordnung von Prozessmodulen relativ zu einem Prozesscontainer. Insbesondere lässt sich die Gesamtanordnung von Prozessmodulen einer wenigstens zwei Prozesscontainer umfassenden Produktionsanlage entsprechend optimieren.

Eine weitere vorteilhafte Ausgestaltung sieht vor, dass als Prozesscontainer ein quaderförmig ausgebildeter, standardisierter Transportcontainer, insbesondere gemäß DIN ISO 668, verwendet wird. Dies ermöglicht einen einfachen Transport von mit Prozessmodulen bestückten Prozesscontainern zu den jeweiligen Produktionsorten unter Verwendung herkömmlicher standardisierter Transportmittel.

Ferner wird vorgeschlagen, dass das Containermodell, die Modulmodelle und die jeweiligen Relativstellungen zwischen den Modulmodellen und dem Containermodell von einer Darstellungseinrichtung angezeigt werden. Hierdurch ist eine einfache Kontrollmöglichkeit für mit der Planung einer entsprechenden Produktionsanlage befasste Personen möglich.

Zusammenfassend wird somit ein Verfahren zur Optimierung einer Anordnung aus wenigstens zwei Prozessmodulen einer modular aufgebauten Produktionsanlage in einem Prozesscontainer geschaffen, wobei zu dieser Optimierung die vorstehend genannten Moduleigenschaften, Belegungseigenschaften und Bedingungen in unterschiedlicher Kombination miteinander herangezogen werden können. Ein Ziel dieser Optimierung ist es, eine möglichst platzsparende Anordnung aus Prozessmodulen zu schaffen, wobei hierzu vorzugsweise Optimierungsfunktionen formuliert und verwendet werden. Sollte eine entsprechend optimierte Anordnung aus Prozessmodulen eine vorgebbare maximale Anzahl der vorgenannten Bedingungen nicht erfüllen, wird die optimierte Anordnung mit einem entsprechenden Qualitätswert versehen, um beispielsweise verschiedene Anordnungen nach entsprechenden Optimierungen miteinander vergleichen zu können.

Im Folgenden wird die Erfindung unter Bezugnahme auf die anliegenden Figuren anhand eines bevorzugten Ausführungsbeispiels exemplarisch erläutert, wobei die nachfolgend dargestellten Merkmale sowohl jeweils für sich genommen als auch in Kombination miteinander einen Aspekt der Erfindung darstellen können. Es zeigen
Figur 1 :eine Darstellung eines Ausführungsbeispiels für die Belegung der Rasterfelder eines Containermodells mit Belegungseigenschaften,
Figur 2:eine Darstellung der Zuordnung des in Figur 1 gezeigten Containermodells mit absoluten Koordinatenpaaren,
Figur 3:eine Darstellung eines Ausführungsbeispiels für die Belegung der Rasterfelder eines Modulmodells mit Moduleigenschaften,
Figur 4:eine Darstellung des Containermodells mit drei darin angeordneten Modulmodellen, und
Figur 5:eine Darstellung des in Figur 4 gezeigten Containermodells nach Optimierung der Anordnung der drei Modulmodelle relativ zueinander und relativ zu dem Containermodell.

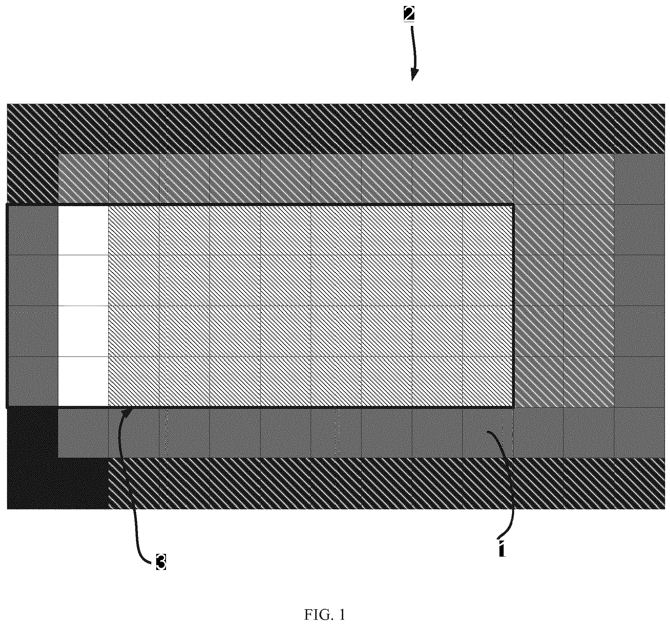

Figur 1 zeigt eine Darstellung eines Ausführungsbeispiels für die Belegung der Rasterfelder 1 eines zweidimensionalen Containermodells 2 mit Belegungseigenschaften. Das Containermodell 2 wurde zu der umrandet dargestellten Grundfläche 3 eines nicht näher dargestellten Prozesscontainers und der Grundfläche 4 einer den Prozesscontainer teilweise umgebenden Containerumgebung vorgebbarer Größe erzeugt. Das Containermodell 2 ist in gleichgroße quadratische Rasterfelder 1 aufgeteilt worden. Die Grundfläche 3 des Prozesscontainers umfasst 4 x 10 Rasterfelder 1. Die Belegungseigenschaften sind ausgewählt aus einer Gruppe, welche die Eigenschaften "nicht belegbar" (schwarz), "nur mit Bedienraum belegbar" (grau), "nur mit funktioneller Einrichtung belegbar" (weiß), "bevorzugt nicht belegt" (schwarz mit Schraffur), "bevorzugt mit Bedienraum belegt" (grau mit Schraffur) und "bevorzugt mit funktioneller Einrichtung belegt" (weiß mit Schraffur) umfasst. Wie zu sehen ist, werden funktionelle Einrichtungen von Prozessmodulen bevorzugt innerhalb des Prozesscontainers angeordnet, wohingegen Prozessmodulen zugeordnete Bedienräume auch außerhalb des Prozesscontainers angeordnet sein können.

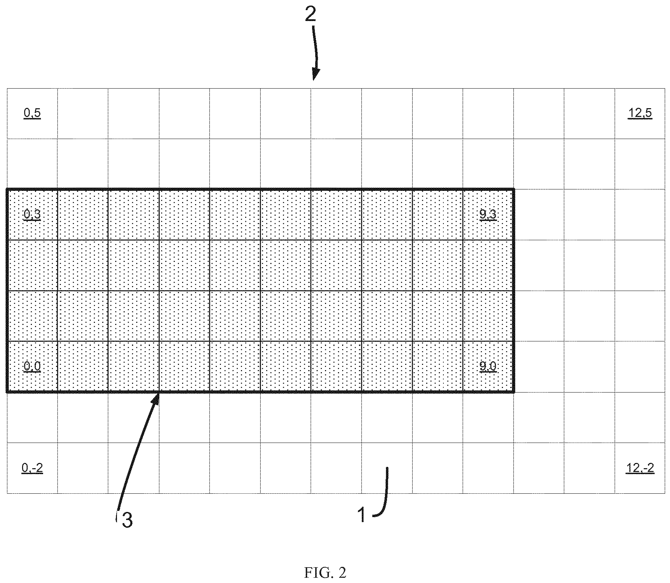

Figur 2 zeigt eine Darstellung der Zuordnung des in Figur 1 gezeigten Containermodells 2 mit absoluten Koordinatenpaaren (x_{abs}, y_{abs}). Der Ursprung des zugrundeliegenden absoluten Koordinatensystems ist innerhalb der Grundfläche 3 des Prozesscontainers angeordnet und mit dem absoluten Koordinatenpaar (0, 0) gekennzeichnet. Jedem Rasterfeld 1 des Containermodells 2 ist des Weiteren eine der Eigenschaften "innerhalb des Containers" (mit Schraffur) oder "außerhalb des Containers" (weiß) zugeordnet.

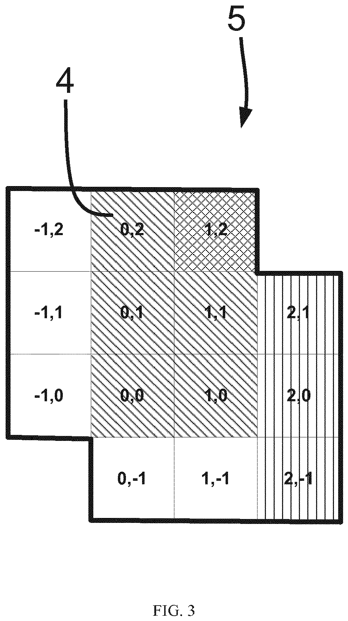

Figur 3 zeigt eine Darstellung eines Ausführungsbeispiels für die Belegung der Rasterfelder 4 eines zu der Grundfläche eines nicht näher dargestellten Prozessmoduls erzeugten Modulmodells 5 mit Moduleigenschaften. Das Modulmodell 5 in gleichgroße quadratische Rasterfelder 4 aufgeteilt, wobei die Dimensionierung der Rasterfelder 4 des Modulmodells 5 derjenigen der Rasterfelder 1 des in den Figuren 1 und 2 gezeigten Containermodells 2 entspricht. Jedem Rasterfeld 4 des Modulmodells 5 ist ein relatives Koordinatenpaar (xᵣₑₗ, yᵣₑₗ) zugeordnet, wobei der Ursprung des zugrundeliegenden relativen Koordinatensystems innerhalb der Grundfläche des Prozessmoduls angeordnet und mit dem relativen Koordinatenpaar (0, 0) gekennzeichnet ist. Jedem Rasterfeld 4 des Modulmodells 5 ist eine Moduleigenschaft bezüglich der Belegung des jeweiligen Rasterfeldes 4 mit einer oberhalb des diesem Rasterfeld 4 entsprechenden Abschnitts der Grundfläche des jeweiligen Prozessmoduls angeordneten, funktionellen Einrichtung des jeweiligen Prozessmoduls oder mit einem oberhalb des diesem Rasterfeld 4 entsprechenden Abschnitts der Grundfläche des jeweiligen Prozessmoduls angeordneten, dem Prozessmodul zugewiesenen Bedienraum zugeordnet. Die Moduleigenschaften bezüglich der Belegung des jeweiligen Rasterfeldes 4 mit einer oberhalb des diesem Rasterfeld 4 entsprechenden Abschnitts der Grundfläche des jeweiligen Prozessmoduls angeordneten, funktionellen Einrichtung des jeweiligen Prozessmoduls sind ausgewählt aus einer Gruppe, die die funktionellen Eigenschaften "stofflicher Eingang" (relatives Koordinatenpaar (1, 2)) und "Prozessaggregat" (relative Koordinatenpaare (0, 2), (0, 1), (1, 1), (0, 0) und (1, 0)). Die Moduleigenschaft "Prozessausrüstung" kann zusätzlich der Rasterfeld 4 mit dem relativen Koordinatenpaar (1, 2) zugeordnet werden. Die Rasterfelder 4 mit den relativen Koordinatenpaaren (-1, 2), (-1, 1), (-1, 0), (0, -1) und (1, -1) sind entsprechend mit der Moduleigenschaft "Bedienraum" belegt. Die Rasterfelder 4 mit den relativen Koordinatenpaaren (2, 1), (2, 0) und (2, -1)) sind mit der Moduleigenschaft "stofflicher Ausgang" belegt.

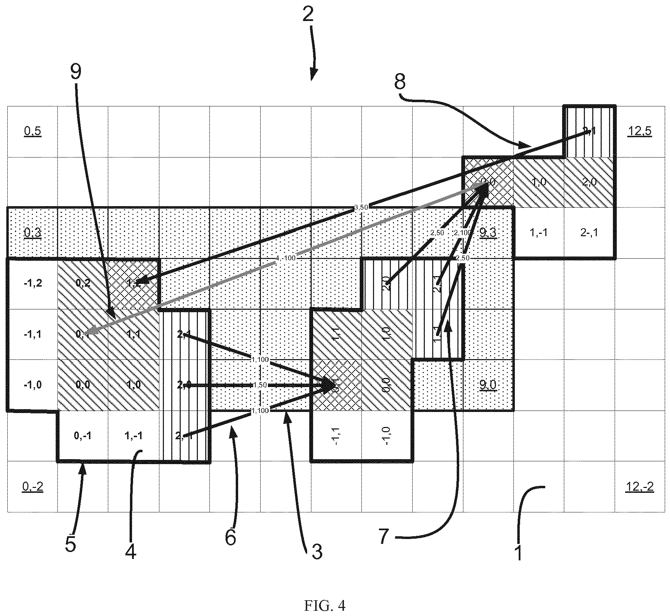

Figur 4 zeigt eine Darstellung des Containermodells 2 mit drei darin angeordneten Modulmodellen 5. Jedem Modulmodell 5 ist eine Position in dem absoluten Koordinatensystem zugeordnet, welche durch die Position des Ursprungs des jeweiligen relativen Koordinatensystems innerhalb des absoluten Koordinatensystems definiert wird. Das links dargestellte Prozessmodul 5 weist beispielsweise die Position in dem absoluten Koordinatensystem auf, die durch das absolute Koordinatenpaar (1, 0) gekennzeichnet ist. Des Weiteren ist jedem Modulmodell 5 eine Ausrichtung relativ zu dem absoluten Koordinatensystem zugeordnet. Da das Containermodell 2 und die Modulmodelle 5 in quadratische Rasterfelder 1 bzw. 4 unterteilt sind, kann ein Modulmodell 5 unter den Relativwinkeln 0°, 90°, 180° oder 270° relativ zu dem absoluten Koordinatensystem ausgerichtet werden. Das links dargestellte Prozessmodul 5 ist unter dem Relativwinkel 0° relativ zu dem absoluten Koordinatensystem ausgerichtet. Das mittlere Prozessmodul 5 ist an der Position mit dem absoluten Koordinatenpaar (7, 0) angeordnet und relativ zu dem absoluten Koordinatensystem unter dem Relativwinkel 270° ausgerichtet. Das rechts dargestellte Prozessmodul 5 ist an der Position mit dem absoluten Koordinatenpaar (9, 4) angeordnet und relativ zu dem absoluten Koordinatensystem unter dem Relativwinkel 0° ausgerichtet.

In diesem Zustand des Optimierungsvorgangs werden alle möglichen Verbindungsvarianten zwischen Rasterfeldern 4 verschiedener Modulmodelle 5, denen jeweils eine funktionellen Einrichtungen zugeordnet ist, ermittelt, wobei jede Verbindungsvariante mit einem Wert aus einem vorgebbaren Wertebereich, insbesondere aus dem Wertebereich {-100,..., 100}, gewichtet wird. Beispielsweise können die mit der Eigenschaft "stofflicher Ausgang" belegten Rasterfelder 4 des links dargestellten Modulmodells 5 mit dem mit der Eigenschaft "stofflicher Eingang" belegten Rasterfeld 4 des in der Mitte dargestellten Modulmodells 5 verbunden werden. Diese stofflichen Verbindungen zwischen dem links dargestellten Modulmodell 5 und dem in der Mitte dargestellten Modulmodell 5 ist in Figur 4 mit der Ziffer 1 gekennzeichnet. In Figur 4 sind diese Verbindungsvarianten durch Pfeile 6 angedeutet. Die Verbindungsvariante, nach der das Rasterfeld 4 mit den relativen Koordinatenpaaren (2, 0) des links dargestellten Modulmodells 5 mit dem Rasterfeld 4 mit den relativen Koordinatenpaaren (0, 1) des in der Mitte dargestellten Modulmodells 5 verbunden wird, ist mit dem Wert 50 gewichtet. Die beiden anderen mit einem Pfeil 6 angedeuteten Verbindungsvarianten sind jeweils mit dem Wert 100 gewichtet.

Entsprechende Verbindungsvarianten zwischen mit der Eigenschaft "stofflicher Ausgang" belegten Rasterfeldern 4 des in der Mitte dargestellten Modulmodells 5 und dem mit der Moduleigenschaft "stofflicher Eingang" belegten Rasterfeld des rechts dargestellten Modulmodells 5 sind in Figur 4 mit der Ziffer 2 gekennzeichnet und durch Pfeile 7 angedeutet. Die Verbindungsvariante, nach der das Rasterfeld 4 mit den relativen Koordinatenpaaren (2, -1) des in der Mitte dargestellten Modulmodells 5 mit dem Rasterfeld 4 mit den relativen Koordinatenpaaren (0, 0) des rechts dargestellten Modulmodells 5 verbunden wird, ist mit dem Wert 100 gewichtet. Die andere mit einem Pfeil 7 angedeuteten Verbindungsvariante ist mit dem Wert 50 gewichtet.

Eine Verbindungsvariante zwischen dem mit der Eigenschaft "stofflicher Ausgang" belegten Rasterfeldern 4 des links dargestellten Modulmodells 5 und dem mit der Moduleigenschaft "stofflicher Eingang" belegten Rasterfeld des rechts dargestellten Modulmodells 5 ist in Figur 4 mit der Ziffer 3 gekennzeichnet und durch den Pfeil 8 angedeutet. Diese Verbindungsvariante, nach der das Rasterfeld 4 mit den relativen Koordinatenpaaren (1, 2) des links dargestellten Modulmodells 5 mit dem Rasterfeld 4 mit den relativen Koordinatenpaaren (0, 0) des rechts dargestellten Modulmodells 5 verbunden wird, ist mit dem Wert 50 gewichtet.

Eine Verbindungsvariante zwischen dem mit der Eigenschaft "Prozessausrüstung" belegten Rasterfeldern 4 des links dargestellten Modulmodells 5 und dem mit der Moduleigenschaft "stofflicher Eingang" belegten Rasterfeld des rechts dargestellten Modulmodells 5 ist in Figur 4 mit der Ziffer 4 gekennzeichnet und durch den Pfeil 9 angedeutet. Diese Verbindungsvariante, nach der das Rasterfeld 4 mit den relativen Koordinatenpaaren (0, 1) des links dargestellten Modulmodells 5 mit dem Rasterfeld 4 mit den relativen Koordinatenpaaren (0, 0) des rechts dargestellten Modulmodells 5 verbunden wird, ist mit dem Wert -100 gewichtet. Diese Verbindungsvariante betrifft somit eine abstoßende Beziehung zwischen dem links dargestellten Modulmodell und dem rechts dargestellten Modulmodell.

Weitere Verbindungsvarianten werden ebenfalls bestimmt und entsprechend gewichtet. Aus Übersichtlichkeitsgründen sind weitere Verbindungsvarianten jedoch nicht in Figur 4 dargestellt.

Verbindungsvarianten, die, wie die zuletzt Genannte, mit einem negativen Wert gewichtet sind, führen zu einer Maximierung des Abstandes zwischen diesen Verbindungsvarianten zugehörigen Rasterfeldern 4, und Verbindungsvarianten, die, wie die übrigen oben genannten Verbindungsvarianten, mit einem positiven Wert gewichtet sind, führen zu einer Minimierung des Abstandes zwischen diesen Verbindungsvarianten zugehörigen Rasterfeldern. Bei mehreren Verbindungsvarianten mit vergleichbaren Gewichtungen mit positiven Werten, wie es beispielsweise für die mit den Ziffern 1 bzw. 2 gekennzeichneten Verbindungsvarianten der Fall ist, wird vorzugsweise diejenige Verbindungsvariante ausgewählt, welche mit dem kleinsten positiven Wert gewichtet ist.

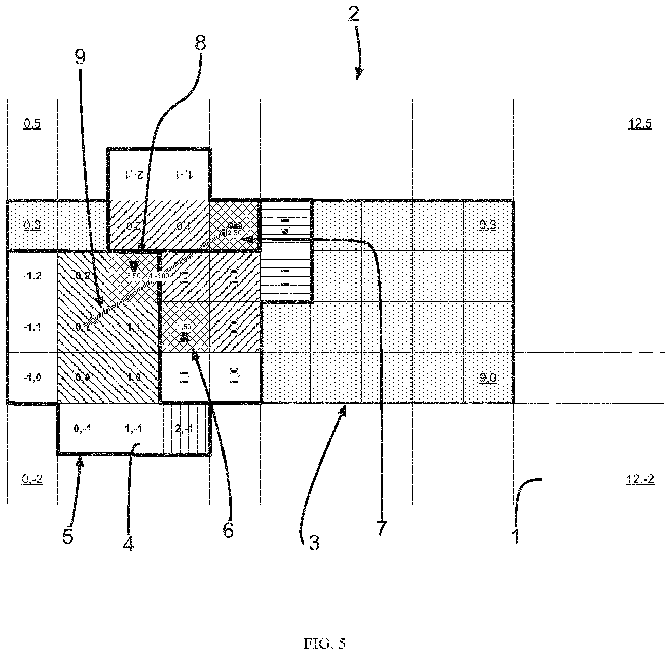

Figur 5 zeigt eine Darstellung des in Figur 4 gezeigten Containermodells 2 nach Optimierung der Anordnung der drei Modulmodelle 5 relativ zueinander und relativ zu dem Containermodell 2. Wie zu erkennen ist, befinden sich die Rasterfelder 4 der Modulmodelle 5, denen eine funktionelle Einrichtung des jeweiligen Prozessmoduls zugeordnet ist, alle innerhalb der Grundfläche 3 des nicht näher dargestellten Prozesscontainers. Jedem Modulmodell 5 ist eine optimierte Position in dem absoluten Koordinatensystem zugeordnet, welche durch die Position des Ursprungs des jeweiligen relativen Koordinatensystems innerhalb des absoluten Koordinatensystems definiert wird. Die optimierte Position des links dargestellten Prozessmoduls 5 entspricht der in Figur 4 gezeigten Ausgangsposition dieses Modulmodells 5 vor Durchführung der Optimierung. Das mittlere Prozessmodul 5 ist an der optimierten Position mit dem absoluten Koordinatenpaar (4, 1) angeordnet und relativ zu dem absoluten Koordinatensystem unter dem Relativwinkel 270° ausgerichtet. Das rechts dargestellte Prozessmodul 5 ist an der optimierten Position mit dem absoluten Koordinatenpaar (4, 3) angeordnet und relativ zu dem absoluten Koordinatensystem unter dem Relativwinkel 180° ausgerichtet. Diese optimierte Anordnung der Modulmodelle 5 in dem Containermodell 2 wird von einer nicht näher dargestellten Darstellungseinrichtung angezeigt.

## Patentansprüche

1. Computerimplementiertes Verfahren zum Herstellen eines zweidimensionalen Anlagenmodells einer modular aufgebauten Produktionsanlage für die Produktion eines chemischen Produktes, wobei die Produktionsanlage wenigstens zwei produktionstechnisch miteinander verbindbare Prozessmodule zur jeweiligen Durchführung eines für die Produktion erforderlichen Gesamtprozesses oder eines bestimmten Prozessabschnitts und mindestens einen Prozesscontainer aufweist, in dem die Prozessmodule wenigstens teilweise bestimmungsgemäß unterbringbar sind, wobei es sich beim Prozesscontainer um eine als Ganzes transportierbare Einheit handelt, und
- wobei zu jedem Prozesscontainer ein gemeinsames zweidimensionales Containermodell (2) seiner Grundfläche (3) und der Grundfläche (3) einer den Prozesscontainer zumindest teilweise umgebenden Containerumgebung vorgebbarer Größe erzeugt wird,
- wobei zu jedem Prozessmodul ein zweidimensionales Modulmodell (5) seiner Grundfläche erzeugt wird,
- wobei das Containermodell (2) und die Modulmodelle (5) in gleichgroße, vorzugsweise quadratische, Rasterfelder (1, 4) aufgeteiltwerden,
- wobei jedem Rasterfeld (4) eines Modulmodells (5) eine Moduleigenschaft bezüglich der Belegung des jeweiligen Rasterfeldes (4) mit einer oberhalb des diesem Rasterfeld (4) entsprechenden Abschnitts der Grundfläche des jeweiligen Prozessmoduls angeordneten, funktionellen Einrichtung des jeweiligen Prozessmoduls, mit einem oberhalb des diesem Rasterfeld (4) entsprechenden Abschnitts der Grundfläche des jeweiligen Prozessmoduls angeordneten, dem Prozessmodul zugewiesenen Bedienraum oder mit einem oberhalb des diesem Rasterfeld (4) entsprechenden Abschnitts der Grundfläche des jeweiligen Prozessmoduls angeordneten stofflichen Ausgang des Prozessmoduls zugeordnet wird,
- wobei jedem Rasterfeld (1) des Containermodells (2) eine der Eigenschaften "innerhalb des Containers" oder "außerhalb des Containers" sowie eine Belegungseigenschaft bezüglich der Belegbarkeit bzw. Nichtbelegbarkeit des jeweiligen Rasterfeldes (1) mit einer Moduleigenschaft zugeordnet wird,
- wobei die Modulmodelle (5) unter Berücksichtigung der Moduleigenschaften und der Belegungseigenschaften in dem Containermodell (2) angeordnet werden.

2. Computerimplementiertes Verfahren nach Anspruch 1, **dadurch gekennzeichnet, dass** die Belegungseigenschaften ausgewählt werden aus einer Gruppe, die zumindest die Eigenschaften umfasst: nicht belegbar, nur mit Bedienraum belegbar, nur mit funktioneller Einrichtung belegbar, bevorzugt nicht belegt, bevorzugt mit Bedienraum belegt und bevorzugt mit funktioneller Einrichtung belegt.

3. Computerimplementiertes Verfahren nach einem der vorhergehenden Ansprüche, **dadurch gekennzeichnet, dass** jedem Rasterfeld (1) des Containermodells (2) ein absolutes ganzzahliges Koordinatenpaar (x_{abs}, y_{abs}) zugeordnet wird, wobei der Ursprung des zugrundeliegenden absoluten Koordinatensystems innerhalb der Grundfläche (3) des Prozesscontainers angeordnet wird.

4. Computerimplementiertes Verfahren nach einem der vorhergehenden Ansprüche, **dadurch gekennzeichnet, dass** jedem Rasterfeld (4) eines Modulmodells (5) ein relatives ganzzahliges Koordinatenpaar (xᵣₑₗ, yᵣₑₗ) zugeordnet wird, wobei der Ursprung des zugrundeliegenden relativen Koordinatensystems innerhalb der Grundfläche des Prozessmoduls angeordnet wird.

5. Computerimplementiertes Verfahren nach Anspruch 4, **dadurch gekennzeichnet, dass** jedem Modulmodell (5) eine Position in dem absoluten Koordinatensystem zugeordnet wird, welche durch die Position des Ursprungs des jeweiligen relativen Koordinatensystems innerhalb des absoluten Koordinatensystems definiert wird.

6. Computerimplementiertes Verfahren nach einem der Ansprüche 3 bis 5, **dadurch gekennzeichnet, dass** jedem Modulmodell (5) eine Ausrichtung relativ zu dem absoluten Koordinatensystem zugeordnet wird.

7. Computerimplementiertes Verfahren nach einem der vorhergehenden Ansprüche, **dadurch gekennzeichnet, dass** alle möglichen Verbindungsvarianten zwischen Rasterfeldern (4) verschiedener Modulmodelle (5), denen jeweils eine funktionellen Einrichtungen zugeordnet ist, ermittelt werden, wobei jede Verbindungsvariante mit einem Wert aus einem vorgebbaren Wertebereich, insbesondere aus dem Wertebereich {-100,..., 100}, gewichtet wird.

8. Computerimplementiertes Verfahren nach Anspruch 7, **dadurch gekennzeichnet, dass** Verbindungsvarianten, die mit einem negativen Wert gewichtet sind, zu einer Maximierung des Abstandes zwischen diesen Verbindungsvarianten zugehörigen Rasterfeldern (4) führen, und dass Verbindungsvarianten, die mit einem positiven Wert gewichtet sind, zu einer Minimierung des Abstandes zwischen diesen Verbindungsvarianten zugehörigen Rasterfeldern (4) führen.

9. Computerimplementiertes Verfahren nach Anspruch 7 oder 8, **dadurch gekennzeichnet, dass** bei mehreren Verbindungsvarianten mit vergleichbaren Gewichtungen mit positiven Werten diejenige Verbindungsvariante ausgewählt wird, welche mit dem kleinsten positiven Wert gewichtet ist.

10. Computerimplementiertes Verfahren nach einem der vorhergehenden Ansprüche, **dadurch gekennzeichnet, dass** die Anordnung der Modulmodelle (5) in dem Containermodell (2) unter Berücksichtigung von wenigstens einer der weiteren Bedingungen erfolgt, ausgewählt aus der Gruppe:
- mit einem Rasterfeld (4) eines Modulmodells (5), dem eine funktionelle Einrichtung des jeweiligen Prozessmoduls zugeordnet ist, darf nicht ein Rasterfeld (1) des Containermodells (2) belegt werden, das bereits mit einem Rasterfeld (4) eines weiteren Modulmodells (5) belegt ist, dem eine funktionelle Einrichtung des jeweiligen weiteren Prozessmoduls zugeordnet ist;
- mit einem Rasterfeld (4) eines Modulmodells (5), dem ein dem jeweiligen Prozessmodul zugewiesener Bedienraum zugeordnet ist, darf nicht ein Rasterfeld (1) des Containermodells (2) belegt werden, das bereits von einem Rasterfeld (4) eines weiteren Modulmodells (5) belegt ist, dem eine funktionelle Einrichtung des jeweiligen weiteren Prozessmoduls zugeordnet ist;
- mit einem Rasterfeld (4) eines Modulmodells (5), dem eine funktionelle Einrichtung des jeweiligen Prozessmoduls zugeordnet ist, darf nicht ein Rasterfeld (1) des Containermodells (2) belegt werden, dem die Belegungseigenschaft "nicht belegbar" oder "nur mit Bedienraum belegbar" zugeordnet ist;
- mit einem Rasterfeld (4) eines Modulmodells (5), dem ein dem jeweiligen Prozessmodul zugewiesener Bedienraum zugeordnet ist, darf nicht ein Rasterfeld (1) des Containermodells (2) belegt werden, dem die Belegungseigenschaft "nicht belegbar" oder "nur mit funktioneller Einrichtung belegbar" zugeordnet ist.

11. Computerimplementiertes Verfahren nach einem der Ansprüche 2 bis 10, **dadurch gekennzeichnet, dass** die Anordnung der Modulmodelle (5) in dem Containermodell (2) unter Berücksichtigung von wenigstens einer der weiteren Bedingungen erfolgt, ausgewählt aus der Gruppe:
- ein Rasterfeld (4) eines Modulmodells (5), dem ein dem jeweiligen Prozessmodul zugewiesener Bedienraum zugeordnet ist, sollte auf einem Rasterfeld (1) des Containermodells (2) angeordnet werden, das bereits von einem Rasterfeld (4) eines weiteren Modulmodells (5) belegt ist, dem ein dem jeweiligen weiteren Prozessmodul zugewiesener Bedienraum zugeordnet ist;
- ein Rasterfeld (4) eines Modulmodells (5), dem eine funktionelle Einrichtung des jeweiligen Prozessmoduls zugeordnet ist, sollte auf einem Rasterfeld (1) des Containermodells (2) angeordnet werden, dem die Belegungseigenschaft "nur mit funktioneller Einrichtung belegbar" oder "bevorzugt mit funktioneller Einrichtung belegt" zugeordnet ist;
- ein Rasterfeld (4) eines Modulmodells (5), dem ein dem jeweiligen Prozessmodul zugewiesener Bedienraum zugeordnet ist, sollte auf einem Rasterfeld (1) des Containermodells (2) angeordnet werden, dem die Belegungseigenschaft "nur mit Bedienraum belegbar" oder "bevorzugt mit Bedienraum belegt" zugeordnet ist;
- ein Rasterfeld (4) eines Modulmodells (5), dem eine funktionelle Einrichtung des jeweiligen Prozessmoduls zugeordnet ist, sollte auf einem Rasterfeld (1) des Containermodells (2) angeordnet werden, das bereits mit einem Rasterfeld (4) eines weiteren Modulmodells (5) belegt ist, dem ein stofflicher Ausgang des jeweiligen weiteren Prozessmoduls zugeordnet ist;
- ein Rasterfeld (4) eines Modulmodells (5), dem ein stofflicher Ausgang des jeweiligen Prozessmoduls zugeordnet ist, sollte auf einem Rasterfeld (1) des Containermodells (2) angeordnet werden, das bereits mit einem Rasterfeld (4) eines weiteren Modulmodells (5) belegt ist, dem eine funktionelle Einrichtung des jeweiligen weiteren Prozessmoduls zugeordnet ist.

12. Computerimplementiertes Verfahren nach einem der vorhergehenden Ansprüche, **dadurch gekennzeichnet, dass** die Anordnung der Modulmodelle (5) in dem Containermodell (2) unter Berücksichtigung von wenigstens einer der weiteren Bedingungen erfolgt, ausgewählt aus der Gruppe:
- die Prozessmodule sollten über eine Längsseite des Prozesscontainers in diesen einbringbar sein;
- Bedienräume und Wartungsräume der Prozessmodule sollten nach bestimmungsgemäßer Anordnung der Prozessmodule zugänglich sein;
- die Prozessmodule sollten einzeln aus dem Prozesscontainer entfernbar bzw. in diesen einbaubar sein, ohne dass hierzu andere Prozessmodule entfernt werden müssen;
- Prozessströme zwischen bestimmungsgemäß angeordneten Prozessmodulen sollten nicht dritte Prozessmodule schneiden.

13. Computerimplementiertes Verfahren nach einem der vorhergehenden Ansprüche, **dadurch gekennzeichnet, dass** die Anordnung der Modulmodelle (5) in dem Prozesscontainer zugeordneten Containermodell (2) unter Berücksichtigung der Anordnung von Modulmodellen (5) in einem weiteren Prozesscontainer zugeordneten weiteren Containermodell (2) erfolgt, wobei der weitere Prozesscontainer über, unter oder neben dem Prozesscontainer angeordnet wird.

14. Computerimplementiertes Verfahren nach einem der vorhergehenden Ansprüche, **dadurch gekennzeichnet, dass** als Prozesscontainer ein quaderförmig ausgebildeter, standardisierter Transportcontainer, insbesondere gemäß DIN ISO 668, verwendet wird.

15. Computerimplementiertes Verfahren nach einem der vorhergehenden Ansprüche, **dadurch gekennzeichnet, dass** das Containermodell (2), die Modulmodelle (5) und die jeweiligen Relativstellungen zwischen den Modulmodellen (5) und dem Containermodell (2) von einer Darstellungseinrichtung angezeigt werden.

## Claims

1. Computerized method for producing a two-dimensional plant model of a modular production plant for producing a chemical product, wherein the production plant has at least two process modules, which can be connected to one another for production purposes and are intended to respectively carry out an overall process required for production or a particular process section, and at least one process container in which the process modules can be at least partially accommodated as intended, wherein the process container is a unit which can be transported as a whole, and
- wherein, for each process container, a common two-dimensional container model (2) of its base area (3) and of the base area (3) of a container environment at least partially surrounding the process container and of a predefinable size is generated,
- wherein, for each process module, a two-dimensional module model (5) of its base area is generated,
- wherein the container model (2) and the module models (5) are divided into grid fields (1, 4) which are of the same size and are preferably square,
- wherein each grid field (4) of a module model (5) is assigned a module property concerning the occupancy of the respective grid field (4) by a functional device of the respective process module, which functional device is arranged above that section of the base area of the respective process module which corresponds to this grid field (4), by an operations room which is allocated to the process module and is arranged above that section of the base area of the respective process module which corresponds to this grid field (4), or by a material output of the process module, which output is arranged above that section of the base area of the respective process module which corresponds to this grid field (4),
- wherein each grid field (1) of the container model (2) is assigned one of the properties "inside the container" or "outside the container" and an occupancy property concerning the possibility or impossibility of the respective grid field (1) being occupied by a module property,
- wherein the module models (5) are arranged in the container model (2) taking into account the module properties and the occupancy properties.

2. Computerized method according to Claim 1, **characterized in that** the occupancy properties are selected from a group comprising at least the following properties: cannot be occupied, can be occupied only by an operations room, can be occupied only by a functional device, preferably not occupied, preferably occupied by an operations room and preferably occupied by a functional device.

3. Computerized method according to one of the preceding claims, **characterized in that** each grid field (1) of the container model (2) is assigned an absolute integer coordinate pair (x_{abs}, y_{abs}), wherein the origin of the underlying absolute coordinate system is arranged inside the base area (3) of the process container.

4. Computerized method according to one of the preceding claims, **characterized in that** each grid field (4) of a module model (5) is assigned a relative integer coordinate pair (xᵣₑₗ, yᵣₑₗ), wherein the origin of the underlying relative coordinate system is arranged inside the base area of the process module.

5. Computerized method according to Claim 4, **characterized in that** each module model (5) is assigned a position in the absolute coordinate system, which position is defined by the position of the origin of the respective relative coordinate system inside the absolute coordinate system.

6. Computerized method according to one of Claims 3 to 5, **characterized in that** each module model (5) is assigned an orientation relative to the absolute coordinate system.

7. Computerized method according to one of the preceding claims, **characterized in that** all possible connection variants between grid fields (4) of different module models (5), which are each assigned a functional device, are determined, wherein each connection variant is weighted with a value from a predefinable range of values, in particular from the range of values {-100,..., 100}.

8. Computerized method according to Claim 7, **characterized in that** connection variants weighted with a negative value result in the distance between grid fields (4) associated with these connection variants being maximized, and **in that** connection variants weighted with a positive value result in the distance between grid fields (4) associated with these connection variants being minimized.

9. Computerized method according to Claim 7 or 8, **characterized in that**, in the case of a plurality of connection variants with comparable weightings with positive values, that connection variant which is weighted with the smallest positive value is selected.

10. Computerized method according to one of the preceding claims, **characterized in that** the module models (5) are arranged in the container model (2) taking into account at least one of the further conditions selected from the following group:
- a grid field (4) of a module model (5) assigned a functional device of the respective process module must not occupy a grid field (1) of the container model (2) which has already been occupied by a grid field (4) of a further module model (5) assigned a functional device of the respective further process module;
- a grid field (4) of a module model (5) assigned an operations room allocated to the respective process module must not occupy a grid field (1) of the container model (2) which has already been occupied by a grid field (4) of a further module model (5) assigned a functional device of the respective further process module;
- a grid field (4) of a module model (5) assigned a functional device of the respective process module must not occupy a grid field (1) of the container model (2) assigned the occupancy property "cannot be occupied" or "can be occupied only by an operations room";
- a grid field (4) of a module model (5) assigned an operations room allocated to the respective process module must not occupy a grid field (1) of the container model (2) assigned the occupancy property "cannot be occupied" or "can be occupied only by a functional device".

11. Computerized method according to one of Claims 2 to 10, **characterized in that** the module models (5) are arranged in the container model (2) taking into account at least one of the further conditions selected from the following group:
- a grid field (4) of a module model (5) assigned an operations room allocated to the respective process module should be arranged in a grid field (1) of the container model (2) which has already been occupied by a grid field (4) of a further module model (5) assigned an operations room allocated to the respective further process module;
- a grid field (4) of a module model (5) assigned a functional device of the respective process module should be arranged in a grid field (1) of the container model (2) assigned the occupancy property "can be occupied only by a functional device" or "preferably occupied by a functional device";
- a grid field (4) of a module model (5) assigned an operations room allocated to the respective process module should be arranged in a grid field (1) of the container model (2) assigned the occupancy property "can be occupied only by an operations room" or "preferably occupied by an operations room";
- a grid field (4) of a module model (5) assigned a functional device of the respective process module should be arranged in a grid field (1) of the container model (2) which has already been occupied by a grid field (4) of a further module model (5) assigned a material output of the respective further process module;
- a grid field (4) of a module model (5) assigned a material output of the respective process module should be arranged in a grid field (1) of the container model (2) which has already been occupied by a grid field (4) of a further module model (5) assigned a functional device of the respective further process module.

12. Computerized method according to one of the preceding claims, **characterized in that** the module models (5) are arranged in the container model (2) taking into account at least one of the further conditions selected from the following group:
- the process modules should be able to be introduced into the process container via a longitudinal side of the latter;
- operations rooms and maintenance rooms for the process modules should be accessible after the process modules have been arranged as intended;
- the process modules should be able to be individually removed from the process container and installed in the latter without other process modules having to be removed for this purpose;
- process streams between process modules arranged as intended should not intersect third process modules.

13. Computerized method according to one of the preceding claims, **characterized in that** the module models (5) are arranged in the container model (2) assigned to the process container taking into account the arrangement of module models (5) in a further container model (2) assigned to a further process container, wherein the further process container is arranged above, below or beside the process container.

14. Computerized method according to one of the preceding claims, **characterized in that** a square standardized transport container, in particular according to DIN ISO 668, is used as the process container.

15. Computerized method according to one of the preceding claims, **characterized in that** the container model (2), the module models (5) and the respective relative positions between the module models (5) and the container model (2) are displayed by a display device.

## Revendications

1. Procédé de création mis en œuvre par ordinateur d'un modèle d'installation bidimensionnel d'une installation de production modulaire pour la production d'un produit chimique, dans lequel l'installation de production comporte au moins deux modules de traitement pouvant être reliés l'un à l'autre dans le cadre d'un processus de production pour l'exécution respective d'un traitement global nécessaire à la production ou d'une partie de traitement déterminée, et au moins un conteneur de traitement dans lequel les modules de traitement peuvent être logés, au moins en partie, selon les besoins, dans lequel le conteneur de traitement est une unité transportable dans son ensemble, et
- dans lequel, pour chaque conteneur de traitement, un modèle bidimensionnel commun de conteneur (2) représentant sa surface au sol (3) et la surface au sol (3) d'une zone périphérique du conteneur, de dimension prédéfinissable, qui entoure au moins partiellement le conteneur de traitement, est créé,
- dans lequel, pour chaque module de traitement, un modèle bidimensionnel de module (5) représentant sa surface au sol est créé,
- dans lequel le modèle de conteneur (2) et les modèles de modules (5) sont divisés en dalles de grille (1, 4), de préférence carrées, de même taille,
- dans lequel, à chaque dalle de grille (4) d'un modèle de module (5) est attribué un attribut de module indiquant l'occupation de la dalle de grille (4) respective par un dispositif fonctionnel du module de traitement respectif, placé au-dessus de la partie de la surface au sol du module de traitement respectif qui correspond à ladite dalle de grille (4), par un espace de manutention associé au module de traitement, placé au-dessus de la partie de la surface au sol du module de traitement respectif qui correspond à ladite dalle de grille (4), ou par une sortie de matière du module de traitement, placée au-dessus de la partie de la surface au sol du module de traitement respectif qui correspond à ladite dalle de grille (4),
- dans lequel, à chaque dalle de grille (1) du modèle de conteneur (2) est attribué l'un des attributs "à l'intérieur du conteneur" ou "à l'extérieur du conteneur" ainsi qu'un attribut d'occupation indiquant la possibilité d'occupation ou l'impossibilité d'occupation de la dalle de grille (1) respective par un attribut de module,
- dans lequel les modèles de modules (5) sont agencés dans le modèle de conteneur (2) en tenant compte des propriétés de modules et des propriétés d'occupation.

2. Procédé mis en œuvre par ordinateur selon la revendication 1, **caractérisé en ce que** les attributs d'occupation sont sélectionnés dans un groupe comprenant au moins les attributs suivants : impossibilité d'occupation, possibilité d'occupation uniquement par un espace de manutention, possibilité d'occupation uniquement par un dispositif fonctionnel, de préférence non occupé, de préférence occupé par un espace de manutention et de préférence occupé par un dispositif fonctionnel.

3. Procédé mis en œuvre par ordinateur selon l'une des revendications précédentes, **caractérisé en ce qu'**une paire de coordonnées absolues entières (x_{abs}, y_{abs}) est attribuée à chaque dalle de grille (1) du modèle de conteneur (2), dans lequel l'origine du système de coordonnées absolues sous-jacent est placée dans la surface au sol (3) du conteneur de traitement.

4. Procédé mis en œuvre par ordinateur selon l'une des revendications précédentes, **caractérisé en ce qu'**une paire de coordonnées relatives entières (xᵣₑₗ, yᵣₑₗ) est attribuée à chaque dalle de grille (4) d'un modèle de module (5), dans lequel l'origine du système de coordonnées relatives sous-jacent est placée dans la surface au sol du module de traitement.

5. Procédé mis en œuvre par ordinateur selon la revendication 4, **caractérisé en ce qu'**une position dans le système de coordonnées absolues est attribuée à chaque modèle de module (5), laquelle position est définie par la position de l'origine du système de coordonnées relatives respectif à l'intérieur du système de coordonnées absolues.

6. Procédé mis en œuvre par ordinateur selon l'une des revendications 3 à 5, **caractérisé en ce qu'**une orientation par rapport au système de coordonnées absolues est attribuée à chaque modèle de module (5).

7. Procédé mis en œuvre par ordinateur selon l'une des revendications précédentes, **caractérisé en ce que** toutes les variantes de connexion possibles entre les dalles de grille (4) de différents modèles de modules (5), auxquelles un dispositif fonctionnel est respectivement attribué, sont déterminées, dans lequel chaque variante de connexion est pondérée par une valeur se situant dans une plage de valeurs prédéfinissable, en particulier dans la plage de valeurs {-100, ..., 100}.

8. Procédé mis en œuvre par ordinateur selon la revendication 7, **caractérisé en ce que** les variantes de connexion pondérées par une valeur négative conduisent à une maximisation de la distance entre les dalles de grille (4) associées auxdites variantes de connexion, et **en ce que** les variantes de connexion pondérées par une valeur positive conduisent à une minimisation de la distance entre les dalles de grille (4) associées auxdites variantes de connexion.

9. Procédé mis en œuvre par ordinateur selon la revendication 7 ou 8, **caractérisé en ce que**, s'il existe plusieurs variantes de connexion dotées de pondérations comparables par des valeurs positives, la variante de connexion sélectionnée est celle qui est pondérée par la plus petite valeur positive.

10. Procédé mis en œuvre par ordinateur selon l'une des revendications précédentes, **caractérisé en ce que** l'agencement des modèles de modules (5) dans le modèle de conteneur (2) est effectué en tenant compte d'au moins l'une des autres conditions sélectionnées dans le groupe suivant :
- une dalle de grille (1) du modèle de conteneur (2) qui est déjà occupée par une dalle de grille (4) d'un autre modèle de module (5) à laquelle est attribué un dispositif fonctionnel de l'autre module de traitement respectif ne doit pas être occupée par une dalle de grille (4) d'un modèle de module (5) à laquelle est attribué un dispositif fonctionnel du module de traitement respectif ;
- une dalle de grille (1) du modèle de conteneur (2), qui est déjà occupée par une dalle de grille (4) d'un autre modèle de module (5) à laquelle est attribué un dispositif fonctionnel de l'autre module de traitement respectif, ne doit pas être occupée par une dalle de grille (4) d'un modèle de module (5) à laquelle est attribué un espace de manutention associé au module de traitement respectif ;
- une dalle de grille (1) du modèle de conteneur (2), à laquelle est attribué l'attribut d'occupation "impossibilité d'occupation" ou "possibilité d'occupation uniquement par un espace de manutention", ne doit pas être occupée par une dalle de grille (4) d'un modèle de module (5) à laquelle est attribué un dispositif fonctionnel du module de traitement respectif ;
- une dalle de grille (1) du modèle de conteneur (2), à laquelle est attribué l'attribut d'occupation "impossibilité d'occupation" ou "possibilité d'occupation uniquement par un dispositif fonctionnel" ne peut pas être occupée par une dalle de grille (4) d'un modèle de module (5) à laquelle est attribué un espace de manutention associé au module de traitement respectif.

11. Procédé mis en œuvre par ordinateur selon l'une des revendications 2 à 10, **caractérisé en ce que** l'agencement des modèles de modules (5) dans le modèle de conteneur (2) est effectué en tenant compte d'au moins l'une des autres conditions sélectionnées dans le groupe suivant :
- une dalle de grille (4) d'un modèle de module (5), à laquelle est attribué un espace de manutention associé au module de traitement respectif, devrait être placée sur une dalle de grille (1) du modèle de conteneur (2), qui est déjà occupée par une dalle de grille (4) d'un autre modèle de module (5), à laquelle est attribué un espace de manutention associé à l'autre module de traitement respectif ;
- une dalle de grille (4) d'un modèle de module (5), à laquelle est attribué un dispositif fonctionnel du module de traitement respectif, devrait être placée sur une dalle de grille (1) du modèle de conteneur (2), à laquelle est attribué l'attribut d'occupation "possibilité d'occupation uniquement par un dispositif fonctionnel" ou "de préférence occupation par un dispositif fonctionnel" ;
- une dalle de grille (4) d'un modèle de module (5), à laquelle est attribué un espace de manutention associé au module de traitement respectif, devrait être placée sur une dalle de grille (1) du modèle de conteneur (2), à laquelle est attribué l'attribut d'occupation "possibilité d'occupation uniquement par un espace de manutention" ou "de préférence occupation par un espace de manutention" ;
- une dalle de grille (4) d'un modèle de module (5), à laquelle est attribué un dispositif fonctionnel du module de traitement respectif, devrait être placée sur une dalle de grille (1) du modèle de conteneur (2), qui est déjà occupée par une dalle de grille (4) d'un autre modèle de module (5), à laquelle est attribuée une sortie de matière de l'autre module de traitement respectif ;
- une dalle de grille (4) d'un modèle de module (5), à laquelle est attribuée une sortie de matière du module de traitement respectif, devrait être placée sur une dalle de grille (1) du modèle de conteneur (2), qui est déjà occupée par une dalle de grille (4) d'un autre modèle de module (5), à laquelle est attribué un dispositif fonctionnel de l'autre module de traitement respectif.

12. Procédé mis en œuvre par ordinateur selon l'une des revendications précédentes, **caractérisé en ce que** l'agencement des modèles de modules (5) dans le modèle de conteneur (2) est effectué en tenant compte d'au moins l'une des autres conditions sélectionnées dans le groupe suivant :
- les modules de traitement devraient pouvoir être introduits dans le conteneur de traitement par le biais d'un côté longitudinal du conteneur de traitement ;
- des espaces de manutention et des espaces de maintenance des modules de traitement devraient être accessibles selon l'agencement prévu des modules de traitement ;
- les modules de traitement devraient pouvoir être retirés individuellement du conteneur de traitement ou y être installés sans devoir pour cela retirer d'autres modules de traitement ;
- des flux de traitement entre des modules de traitement agencés selon les besoins ne devraient pas s'entrecroiser avec des modules de traitement tiers.

13. Procédé mis en œuvre par ordinateur selon l'une des revendications précédentes, **caractérisé en ce que** l'agencement des modèles de modules (5) dans le modèle de conteneur (2) attribué au conteneur de traitement est effectué en tenant compte de l'agencement de modèles de modules (5) dans un autre modèle de conteneur (2) attribué à un autre conteneur de traitement, dans lequel l'autre conteneur de traitement est placé au-dessus, en-dessous ou à côté du conteneur de traitement.

14. Procédé mis en œuvre par ordinateur selon l'une des revendications précédentes, **caractérisé en ce qu'**un conteneur de transport cubique et normalisé, en particulier selon la norme DIN ISO 668, est utilisé comme conteneur de traitement.

15. Procédé mis en œuvre par ordinateur selon l'une des revendications précédentes, **caractérisé en ce que** le modèle de conteneur (2), les modèles de modules (5) et les positions relatives respectives entre les modèles de modules (5) et le modèle de conteneur (2) sont affichés par un dispositif d'affichage.
